# EUROPEAN PATENT SPECIFICATION

(11) **EP 0 353 308 B1**
(45) Date of publication and mention of the grant of the patent: **23.10.1996**
(21) Application number: 89901603.4
(22) Date of filing: 20.01.1989
(51) Int. Cl.: H01L 27/04, H04N 9/73

(54) **SEMICONDUCTOR DEVICE**
HALBLEITERANORDNUNG
DISPOSITIF A SEMI-CONDUCTEUR

(30) Priority: 22.01.1988 JP 12107/88; 30.05.1988 JP 132103/88
(43) Date of publication of application: 07.02.1990
(73) Proprietor: SONY CORPORATION, Tokyo 141 (JP)
(72) Inventor: SENUMA, Toshitaka, Shinagawa-ku Tokyo 141 (JP); YAMAGUCHI, Futao, Shinagawa-ku Tokyo 141 (JP)
(74) Representative: Turner, James Arthur
(86) International application number: PCT/JP89/00050
(87) International publication number: WO 89/06862

(56) References cited:
- JP-A- 4 883 787
- JP-A- 5 543 812
- JP-A- 6 292 458
- JP-B- 6 124 824
- US-A- 4 211 941
- US-A- 4 214 252
- PATENT ABSTRACTS OF JAPAN, vol. 4, no. 75 (E-13)(557) 31 May 1980 ; & JP-A-55 43 812

## Description

This invention relates to semiconductor apparatus comprising capacitance.

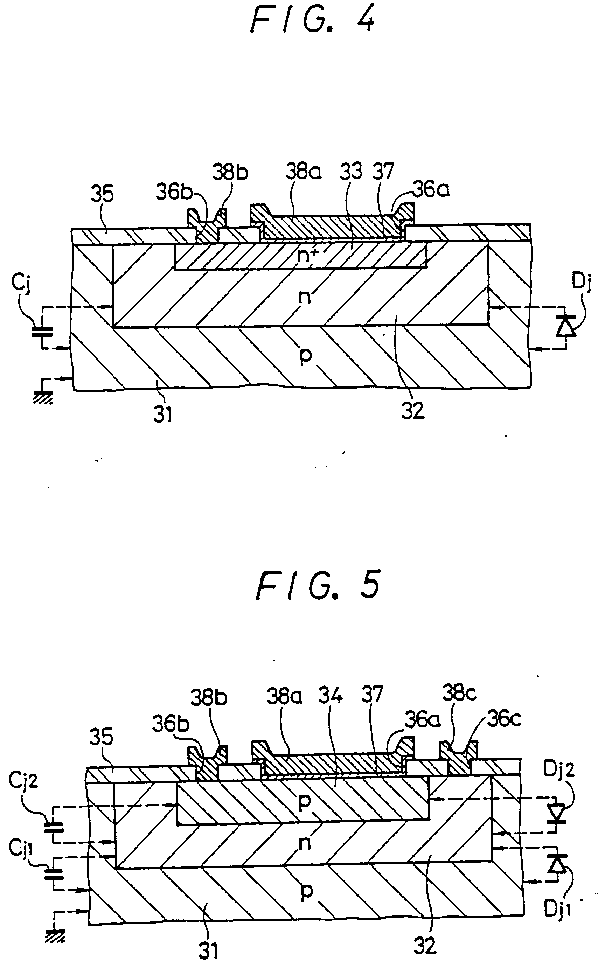

In a known domestic VTR, in a recording system and a reproducing system there is commonly provided an automatic colour control (ACC) circuit in which the amplitude of a colour burst signal is detected to control the gain of a chrominance signal amplifier, thereby maintaining the amplitude of the chrominance signal constant. Figure 4 shows a previously-proposed semiconductor apparatus used in this ACC circuit. Similar features are also shown in US patent specification US-A-4 211 941.

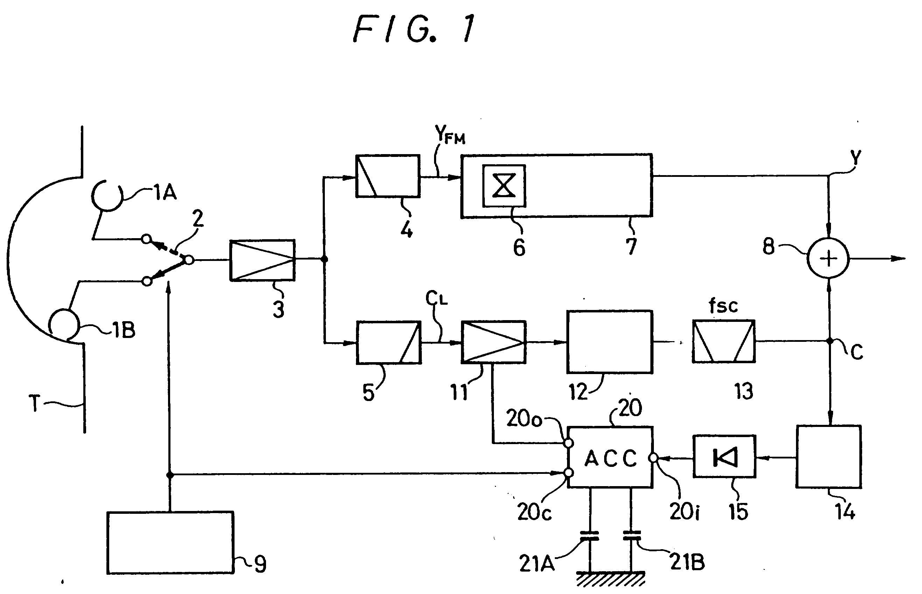

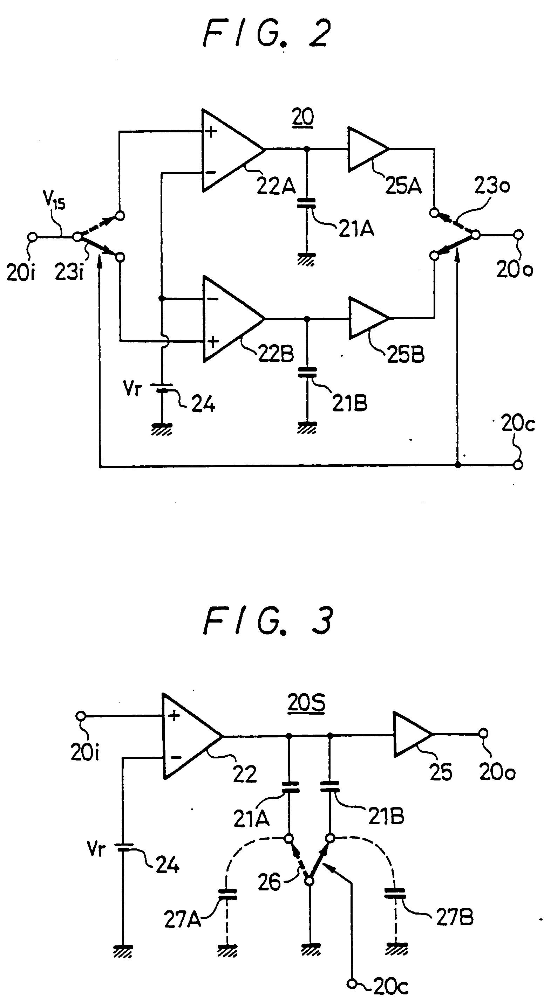

The known VTR and ACC circuit will be described with reference to Figures 1 and 2. In Figure 1, which shows an example of the arrangement of a reproducing system of a VTR, reproduced outputs from a pair of rotary magnetic heads 1A and 1B are commonly supplied through a change-over switch 2 and an amplifier 3 to a high-pass filter 4 and a low-pass filter 5 from which there are separated an FM luminance signal Y_{FM} and a down-converted chrominance signal C_{L}. The signal Y_{FM} is supplied to a luminance signal processing circuit 7 which includes an FM-demodulator 6, and a reproduced luminance signal Y therefrom is supplied to an adder 8.

The signal C_{L} is supplied through a chrominance signal amplifier 11 to a frequency converting circuit 12, in which it is converted to an original carrier chrominance signal C, in response to an output from a local oscillator (not shown). The reproduced carrier chrominance signal C is supplied to the adder 8 through a band-pass filter 13 whose centre frequency is a colour sub-carrier frequency fsc, and the adder 8 derives a colour video signal.

A burst gate circuit 14 is supplied with the output of the band-pass filter 13, and the reproduced colour burst signal extracted thereby is supplied to an ACC detector 15. The detected output therefrom is supplied through an ACC circuit 20 to the chrominance signal amplifier 11, so the gain is ACC-controlled.

To protect the chrominance signal from flicker caused by an output level difference when the characteristics of the heads 1A and 1B are not identical, the ACC circuit 20 employs capacitors 21A and 21B of the same capacitance to form time constant circuits which provide different time constants in each field. The time constant circuits are changed over by a switching pulse from a pulse generator 9 in synchronism with the switching operation of the heads 1A and 1B.

As shown in Figure 2, in the ACC circuit 20, the capacitors 21A and 21B are respectively connected to output terminals of differential amplifiers (comparing circuits) 22A and 22B. The differential amplifiers 22A and 22B are alternately supplied at non-inverting input terminals thereof with a detected output V₁₅ applied to an input terminal 20i of the ACC circuit 20 from the ACC detector 15 through a change-over switch 23i at every field, and they are also commonly supplied at their inverting input terminals with a reference voltage Vr of a reference voltage source 24. The differential amplifiers 22A and 22B respectively supply the corresponding capacitors 21A and 22B with output currents corresponding to differences between the ACC detected output voltage V₁₅ and the reference voltage Vr. The terminal voltages across the capacitors 21A and 21B are alternately supplied through buffer amplifiers 25A and 25B and a change-over switch 23o to an output terminal 20o at every field. The switches 23i and 23o are changed in position at every field in response to a switching pulse from a control terminal 20c in ganged fashion.

In this ACC circuit, the two signal systems respectively including the differential amplifiers 22A and 22B are switched by the switches 23i and 230, which necessitates a large and complicated arrangement. Further, even when they are formed as an integrated circuit on the same semiconductor substrate, there is a risk that an offset will occur between the characteristics of the two differential amplifiers.

To solve this problem, we have previously proposed, in Japanese Utility Model Application 61-200570 (publication number 63-108286), an ACC circuit in which an output of a single comparing circuit is held by a plurality of capacitors which are switched at every field in synchronism with the change-over of rotary heads.

This previously-proposed ACC circuit will be explained with reference to Figure 3. When one head 1A (see Figure 1) scans a magnetic tape, the change-over switch 26 is connected as shown by a dashed line. The ACC detected output from the input terminal 20i and the reference voltage Vr are level-compared by the differential amplifier 22, and a current corresponding to the level difference is supplied from the differential amplifier 22 to one capacitor 21A. Thus, its terminal voltage becomes a value corresponding to the difference between the burst signal level and the reference voltage Vr. When the other head 1B scans the magnetic tape, the switch 26 is connected as shown by a solid line, whereby the other capacitor 21B is charged up similarly as described above.

The terminal voltages across the capacitors 21A and 21B are supplied through, for example, an emitter-follower-type buffer 25 to the output terminal 20o and then supplied to the amplifier 11 (see Figure 1). The gain of the amplifier 11 is therefore controlled such that the level of the colour burst signal coincides with the reference level.

With this ACC circuit, only the single differential amplifier is required, so the circuit can be smaller and simpler, and no offset between differential amplifiers occurs.

When this ACC circuit is formed on a semiconductor circuit (as an IC) including the capacitors 21A and 21B, it is unavoidable that the capacitors 21A and 21B have parasitic capacitances 27A and 27B as shown by dashed lines in Figure 3.

This is because a capacitor in a semiconductor IC is generally formed as a metal insulation substrate (MIS) capacitance as shown in Figure 4.

Referring to Figure 4, a p-type silicon substrate 31 has an n-type epitaxial layer 32 formed on its surface portion as an island-shape. An n⁺-type diffusion layer 33 is selectively formed on the surface portion of the layer 32 by an emitter diffusion-process. Through an oxide film 35 for protecting the surface of the semiconductor, large and small windows 36a and 36b are formed on the diffusion layer 33.

A dielectric layer 37 is, for example, 50nm (500 Å) in thickness and is made of nitride silicon Si₃N₄. The dielectric layer 37 is deposited on the n⁺-type diffusion layer 33 within the large window 36a of the oxide film 35. An Al electrode 38a is deposited on the dielectric layer 37, and an Al electrode 38b is deposited on the diffusion layer 33 within the small window 36b, whereby the diffusion layer 33 and the Al electrode 38a are opposed to each other through the dielectric layer 37, thus forming a capacitor having a capacitance of, for example, 100 pF.

A junction capacitance Cj exists between the n-type island 32 communicated with the n⁺-type diffusion layer 33 and the p-type silicon substrate 31 which is at earth potential, and this junction capacitance Cj forms the parasitic capacitance. The value of the parasitic capacitance depends on constituents of the p-type silicon substrate 31 and the n-type island 32, and is generally about 10% of the capacitance of a capacitor constructed by the MIS technique.

The p-type substrate 31 and the n-type island 32 also have a characteristic of a diode Dj.

If the ACC circuit shown in Figure 3 is formed as an IC, the parasitic capacitances 27A and 27B are produced by the above-noted junction capacitance, so that the independence of the two capacitors 21A and 21B will not be maintained as the switch 26 is changed over.

When the change-over switch 26 is connected as shown by the solid line in Figure 3, to the capacitor 21B earthed thereby, a serially-mixed capacitance of the capacitor 21A and the parasitic capacitance 27A thereof is connected in parallel.

In like manner, when the switch 26 is connected as shown by the dashed line, to the capacitor 21A, a serially-mixed capacitance of the capacitor 21B and the parasitic capacitance 27B thereof is connected in parallel.

Assuming that the capacitance values of the parasitic capacitances 27A and 27B are 10% of the capacitance values of the capacitors 21A and 21B, then the values of the serially-mixed capacitances are a little larger than 9% of the capacitance values of the capacitors 21A and 21B. Thus, cross-talk occurs between the ACC control signals of each field held in the capacitors 21A and 21B. As a result, flicker of the chrominance signal cannot be eliminated completely.

According to the present invention there is provided a semiconductor automatic colour correction circuit, comprising:
a differential amplifier for comparing a detected chrominance signal with a reference signal;
first and second capacitors, each having one electrode connected to the output of the differential amplifier;
a change-over switch for selectively connecting the other electrode of the first capacitor or the other electrode of the second capacitor to earth; and
a buffer amplifier having its input connected to said one electrode of each capacitor and to the output of the differential amplifier;
each capacitor comprising a first semiconductor region of first conductivity type formed in a second semiconductor region of second conductivity type which is disposed in a semiconductor substrate, a dielectric layer overlying said first semiconductor region, a first electrode formed on the dielectric layer, and a second electrode connected to the first semiconductor region, the first and second electrodes providing said one and said other electrodes of the capacitor;
each capacitor having a third electrode connected to said second semiconductor region;
the third electrodes of the first and second capacitors being connected to the output of the buffer amplifier.

Patent specifications JP-A-61/24824 and US-A-4,214,252 describe a semiconductor capacitor similar to the capacitors defined above but do not suggest the use of such a capacitor in an automatic colour correction circuit in order to deal with the problems mentioned above.

In one embodiment of the present invention the first semiconductor region contacts the dielectric layer.

In another embodiment of the present invention each capacitor comprises a third semiconductor region of the second conductivity type being formed in said first semiconductor region of the first conductivity type and being in contact with said dielectric layer, said third semiconductor region and said first semiconductor region both being electrically connected by said second electrode.

The invention will now be described by way of example with reference to the accompanying drawings, throughout which like parts are referred to by like references, and in which:
Figures 1 and 2 are a block diagram and a circuit diagram to which reference has been made;
Figure 3 is a circuit diagram of an arrangement of a previously-proposed ACC circuit;
Figure 4 is a diagrammatic sectional view of a known apparatus;
Figure 5 is a diagrammatic sectional view of semiconductor capacitors used in an embodiment of semiconductor apparatus according to the present invention;
Figures 6 and 7 are circuit diagrams of arrangements to which the present invention is applied; and
Figure 8 is a diagrammatic sectional view of semiconductor capacitors used in a further embodiment of the present invention.

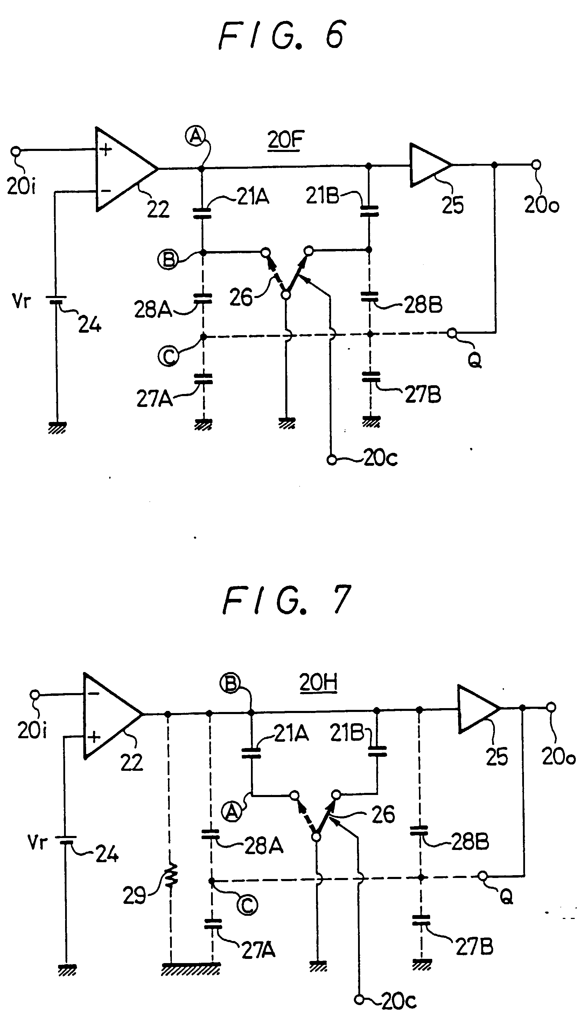

As shown in Figure 5, a p-type diffusion layer 34 is selectively formed on the surface portion of the island-shaped n-type epitaxial layer 32 by a base-diffusion process. A large window 36a and the small window 36b are formed through a protecting film 35 on the p-type diffusion layer 34, and a second small window 36c is formed through the protecting film 35 on the surface of the n-type island 32. Within this small window 36c, an Al electrode 38c is deposited on the n-type island 32.

As described above, a junction capacitance Cj1 and a diode Dj1 are formed between the p-type substrate 31 and the n-type island 32, and a junction capacitance Cj2 and a diode Dj2 are formed between the n-type islands 32 and the p-type diffusion layer 34. Other arrangements are similar to those of Figure 4.

With this arrangement, if a negative potential is supplied to the p-type diffusion layer 34 through the Al electrode 38b, then the diode Dj2 formed between the p-type diffusion layer 34 and the n-type island 32 is reversely biased to prevent the potential of the n-type island 32 from being lowered to the negative region. Thus, the diode Dj1 formed between the island 32 and the p-type substrate 31 is turned ON, thus avoiding excess current from flowing. Moreover, the range of available voltage can be extended. Elimination of the influence of the junction capacitance will be explained below.

Another embodiment of semiconductor apparatus, which is applied to an ACC circuit 20F of a VTR, will be described next with reference to Figure 6. In this case, third and fourth parasitic capacitances 28A and 28B are respectively connected in series between the capacitors 21A and 21B and the corresponding parasitic capacitances 27A and 27B. A junction B between one capacitor 21A and the parasitic capacitance 28A is connected to one fixed contact of the switch 26, while a junction between the other capacitor 21B and the parasitic capacitance 28B is connected to the other fixed contact of the switch 26. A junction C between the first and third parasitic capacitances 27A and 28A and a junction between the second and fourth parasitic capacitances 27B and 28B are both connected to an intermediate terminal Q, and this terminal Q and the output terminal of the buffer 25 are connected to each other.

The third and fourth parasitic capacitances 28A and 28B are formed as shown in Figure 5. The terminal A of the capacitor 21A and the junctions B and C correspond to the Al electrodes 38a, 38b and 38c of Figure 5. Other arrangements are similar to those of Figure 3.

The operation is as follows. When the change-over switch 26 is connected as, for example, shown by a solid line, the capacitor 21B is directly earthed and the capacitor 21A is earthed via the first and third parasitic capacitances 27A and 28A. In this case, the output terminal of the buffer 25 is connected through the intermediate terminal Q to the junction C of the two parasitic capacitances 27A and 28A so that the first parasitic capacitance 27A is connected in parallel with the low output impedance of the buffer 25, so the first parasitic capacitance is substantially short-circuited.

Further, since the potential at the output terminal of the buffer 25 is changed in the same way as the potential at the input terminal thereof is changed, the potential difference between the input and output terminals of the buffer 25 becomes constant. In this circuit, the capacitor 21A and the third parasitic capacitance 28A, for example, are serially connected between the input and output terminals of the buffer 25 so that, even if they are connected to the output terminal of the differential amplifier 22, the voltage across the serially-mixed capacitance becomes constant.

In the example of the previously-proposed semiconductor apparatus shown in Figure 3, the voltage across the serially-mixed capacitances of, for example, the capacitor 21A and the parasitic capacitance 27A is changed together with the voltage across the capacitor 21B.

In the embodiment shown in Figure 6, however, the voltage across the serially-mixed capacitance of, for example, the capacitor 21A and the parasitic capacitance 28A becomes constant as described above so that the independence of the two capacitors 21A and 21B is not damaged. Thus, a cross-talk component can be prevented from being produced between the ACC control signals of each field, and hence flicker of the chrominance signal can be eliminated completely.

Application to the ACC circuit 20H of a VTR, will be explained next with reference to Figure 7.

In Figure 7, similarly to Figure 6, the third and fourth parasitic capacitances 28A and 28B are serially connected between the capacitors 21A and 21B and the corresponding parasitic capacitances 27A and 27B, respectively. In this case, however, the connections of the terminals of the capacitors 21A and 21B are inverted.

That is, electrodes (A) of the capacitors 21A and 21B are respectively connected to the fixed contacts of the change-over switch 26, and the junction B between one capacitor 21A and the parasitic capacitance 28A and the junction between the other capacitor 21B and the parasitic capacitance 28B are both connected to the output terminal of the differential amplifier 22. As described above, the parasitic capacitances, for example, 27A and 28A correspond to the junction capacitances Cj1 and Cj2 of Figure 5, and are accompanied with leak currents on the respective junction surfaces of the p-type substrate 31, the n-type island 32 and the p-type diffusion layer 34. A leak resistor 29 corresponds to the leak currents of the parasitic capacitances 27A, 28A and 27B, 28B. Other arrangements are similar to those of Figure 6.

In Figure 7, the leak resistor 29 is connected to the output terminal of the low impedance of the differential amplifier 22, so that the leak current corresponding to the leak resistor is cancelled out by the output current of the amplifier 22.

Since one terminal A of the capacitor 21A, or the Al electrode 38a is insulated from the p-type diffusion layer 34 by the dielectric layer 37, the leak current is very small, and the influence of leak current in the holding period is also very small.

When the current is negatively fed back from the buffer 25 to the differential amplifier 22, the influence of the leak current can be substantially neglected.

While the embodiments have been described as applied to the ACC circuit of a VTR, the invention is not limited to this, and embodiments can be applied to a wide variety of circuits, such as time-division hold circuits.

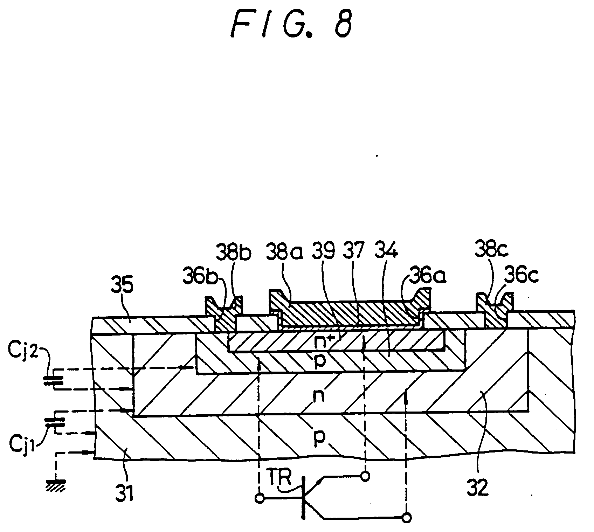

A further embodiment of semiconductor capacitors will now be described with reference to Figure 8. An n⁺-type diffusion layer 39 of low resistance value is selectively formed on the surface portion of the p-type diffusion layer 34 by an emitter-diffusion process. The location of the n⁺-type diffusion layer 39 is determined such that its one border with the p-type diffusion layer 34 in the lateral direction (face direction) is opposed to the small window 36b of the protecting film 35. Other arrangements are similar to those of Figure 5.

In the arrangement of Figure 8, the n⁺-type diffusion layer 39 is contacted with the dielectric layer 37 to form the other electrode and the lead wire of the capacitor by the MIS technique together with the p-type diffusion layer 34. Since the diffusion layer 39 is low in resistance value as described above, the deriving resistance of the MIS capacitor is reduced, the capacitor is reduced in loss and the frequency characteristic can be improved.

The base and emitter of an npn-system transistor TR formed by the n-type island 32, the p-type diffusion layer 34 and the n⁺-type diffusion layer 39 are short-circuited by the Al electrode 38b.

Thus, even when a negative potential is supplied to the n-type island 32 through the Al electrode 38b, the transistor TR is in its OFF state, so that an excess current can be prevented from flowing to the substrate 31.

## Claims

1. A semiconductor automatic colour correction circuit, comprising: a differential amplifier (22) for comparing a detected chrominance signal (20i) with a reference signal (Vr);
first and second capacitors (21A, 21B), each having one electrode connected to the output of the differential amplifier;
a change-over switch (26) for selectively connecting the other electrode of the first capacitor or the other electrode of the second capacitor to earth; and
a buffer amplifier (25) having its input connected to said one electrode of each capacitor and to the output of the differential amplifier;
each capacitor comprising a first semiconductor region (34) of first conductivity type formed in a second semiconductor region (32) of second conductivity type which is disposed in a semiconductor substrate (31), a dielectric layer (37) overlying said first semiconductor region, a first electrode (38a) formed on the dielectric layer, and a second electrode (38b) connected to the first semiconductor region, the first and second electrodes providing said one and said other electrodes of the capacitor;
each capacitor having a third electrode (38c) connected to said second semiconductor region;
the third electrodes of the first and second capacitors being connected to the output (200) of the buffer amplifier.

2. A circuit according to claim 1, wherein the first semiconductor region (34) contacts the dielectric layer (37).

3. A circuit according to claim 1 wherein each capacitor (21A, 21B) comprises a third semiconductor region (39) of the second conductivity type being formed in said first semiconductor region (34) of the first conductivity type and being in contact with said dielectric layer (37), said third semiconductor region (39) and said first semiconductor region (34) both being electrically connected by said second electrode (38b).

## Patentansprüche

1. Halbleiterschaltung zur automatischen Farbkorrektur
mit einem Differenzverstärker (22) zum Vergleichen eines detektierten Chrominanzsignals (20i) mit einem Referenzsignal (Vr),
mit einem ersten und einem zweiten Kondensator (21A, 21B), die jeweils mit einer Elektrode mit dem Ausgang des Differenzverstärkers verbunden sind,
mit einem Umschalter (26) zum wahlweisen Verbinden der anderen Elektrode des ersten Kondensators oder der anderen Elektrode des zweiten Kondensators mit Masse,
sowie mit einem Pufferverstärker (25), dessen Eingang mit der genannten einen Elektrode jedes Kondensators und mit dem Ausgang des Differenzverstärkers verbunden ist,
wobei jeder Kondensator aufweist:
eine erste Halbleiterregion (34) eines ersten Leitfähigkeitstyps, der in einer zweiten Halbleiterregion (32) eines zweiten Leitfähigkeitstyps ausgebildet ist, die in einem Halbleitersubstrat (31) angeordnet ist,
eine dielektrische Schicht (37), die über der ersten Halbleiterregion liegt,
eine erste Elektrode (38a), die auf der dielektrischen Schicht ausgebildet ist,
und eine zweite Elektrode (38b), die mit der ersten Halbleiterregion verbunden ist,
wobei die erste und die zweite Elektrode die genannte eine bzw. die genannte andere Elektrode des Kondensators bilden,
wobei jeder Kondensator ferner eine dritte Elektrode (38c) aufweist, die mit der zweiten Halbleiterregion verbunden ist,
und wobei die dritten Elektroden des ersten und des zweiten Kondensators mit dem Ausgang (20o) des Pufferverstärkers verbunden sind.

2. Schaltung nach Anspruch 1, bei der die erste Halbleiterregion (34) die dielektrische Schicht (37) kontaktiert.

3. Schaltung nach Anspruch 1, bei der jeder Kondensator (21A, 21B) eine dritte Halbleiterregion (39) des zweiten Leitfähigkeitstyps aufweist, die in der ersten Halbleiterregion (34) des ersten Leitfähigkeitstyps ausgebildet ist und mit der dielektrischen Schicht (37) in Kontakt steht, wobei sowohl die dritte Halbleiterregion (39) als auch die erste Halbleiterregion (34) durch die zweite Elektrode (38b) elektrisch miteinander verbunden sind.

## Revendications

1. Circuit de correction automatique de couleur à semiconducteur comprenant :
un amplificateur différentiel (22) pour comparer un signal de chrominance détecté (20i) à un signal de référence (Vr) ;
des premier et second condensateurs (21A, 21B) dont chacun comporte une électrode connectée à la sortie de l'amplificateur différentiel ;
un commutateur de permutation (26) pour connecter sélectivement l'autre électrode du premier condensateur ou l'autre électrode du second condensateur à la terre ; et
un amplificateur tampon (25) ayant son entrée connectée à ladite une électrode de chaque condensateur et à la sortie de l'amplificateur différentiel ;
chaque condensateur comprenant une première région semiconductrice (34) d'un premier type de conductivité formée dans une seconde région semiconductrice (32) d'un second type de conductivité qui est disposée dans un substrat semiconducteur (31), une couche diélectrique (37) chevauchant ladite première région semiconductrice, une première électrode (38a) formée sur la couche diélectrique et une seconde électrode (38b) connectée à la première région semiconductrice, les première et seconde électrodes constituant lesdites une et autre électrodes du condensateur ;
chaque condensateur comportant une troisième électrode (38c) connectée à ladite seconde région semiconductrice ;
les troisièmes électrodes des premier et second condensateurs étant connectées à la sortie (200) de l'amplificateur tampon.

2. Circuit selon la revendication 1, dans lequel la première région semiconductrice (34) entre en contact avec la couche diélectrique (37).

3. Circuit selon la revendication 1, dans lequel chaque condensateur (21A, 21B) comprend une troisième région semiconductrice (39) du second type de conductivité qui est formée dans ladite première région semiconductrice (34) du premier type de conductivité et qui est en contact avec ladite couche diélectrique (37), ladite troisième région semiconductrice (39) et ladite première région semiconductrice (34) étant toutes deux connectées électriquement par ladite seconde électrode (38b).
